# EUROPÄISCHE PATENTANMELDUNG

(11) **EP 1 265 293 A2**
(43) Veröffentlichungstag der Anmeldung: **11.12.2002**
(21) Anmeldenummer: 02011123.3
(22) Anmeldetag: 18.05.2002
(51) Int. Cl.: H01L 29/06, H01L 29/08, H01L 29/417, H01L 29/861, H01L 29/78, H01L 21/225, H01L 21/3063, H01L 21/329, H01L 21/336

(54) **Halbleiterbauelement mit Poren und Verfahren zu dessen Herstellung**

(30) Priorität: 08.06.2001 DE 10127950
(71) Anmelder: Infineon Technologies AG, 81669 München (DE)
(72) Erfinder: Lehmann, Volker, 80689 München (DE); Schubert, Axel, 81543 München (DE)
(74) Vertreter: Patentanwälte Westphal, Mussgnug & Partner

(57) **Zusammenfassung**

Die vorliegende Erfindung betrifft ein Verfahren zur Herstellung eines Halbleiterbauelements, das folgende Merkmale aufweist:
- Bereitstellen eines Halbleiterkörpers (100) mit einer ersten und einer zweiten Oberfläche (101, 102),
- Herstellen einer Vielzahl von Poren (103) in dem Halbleiterkörper (100), die sich ausgehend von der ersten Oberfläche (101) in den Halbleiterkörper (100) hinein erstrecken und die unterhalb der zweiten Oberfläche (102) enden,
- Steigern der elektrischen Leitfähigkeit des Halbleiterkörpers (100) im Bereich der Poren (103).

Die Erfindung betrifft des weiteren ein Halbleiterbauelement.

## Beschreibung

Die vorliegende Erfindung betrifft ein Halbleiterbauelement, das in einem Halbleiterkörper bzw. Chip integriert ist, der eine erste und eine zweite Oberfläche aufweist, wobei Anschlusskontakte an den Oberflächen zur Kontaktierung des Halbleiterbauelements angeordnet sind.

Ein derartiges Halbleiterbauelement ist beispielsweise ein vertikaler Transistor, wie er in Stengl/Tihanyi: "Leistungs-MOS-FET-Praxis", Pflaum Verlag, München 1992, Seite 37, beschrieben ist. Dieser Transistor weist ein stark n-dotiertes Halbleitersubstrat auf, auf dem eine schwächer n-dotierte Epitaxieschicht aufgebracht ist. In der Epitaxieschicht sind p-dotierte Body-Zonen angeordnet, in denen wiederum n-dotierte Source-Zonen angeordnet sind. Die Source- und die Body-Zonen sind bei diesem Bauelement an einer Vorderseite des durch das Substrat und die Epitaxieschicht gebildeten Halbleiterkörpers kontaktiert. Das Substrat bildet eine Drain-Zone des Transistors, die an einer Rückseite des Halbleiterkörpers kontaktiert ist. Die Dicke und die Dotierung der Epitaxieschicht, die als Driftzone wirkt, bestimmen maßgeblich die elektrischen Eigenschaften des bekannten Bauelements, insbesondere dessen Sperrspannung und dessen Einschaltwiderstand. Das Substrat, auf welchem die Epitaxieschicht aufgebracht ist, ist möglichst hoch dotiert, um den Einschaltwiderstand möglichst wenig zu beeinflussen.

Das stark dotierte Substrat dient im wesentlichen als Träger und ist erforderlich, um einen Wafer, in dem eine Vielzahl solcher Transistoren hergestellt werden und aus dem die Chips mit den Transistoren am Ende des Herstellungsverfahrens herausgesägt werden, während des Herstellungsverfahrens handhaben zu können. Ein Wafer, der ausschließlich die Dicke der die elektrischen Eigenschaften bestimmenden Driftzone aufweist ist theoretisch ausreichend, für die Herstellung des Transistors praktisch jedoch nicht handhabbar, da die Dicke der Driftzone üblicherweise so gering ist, dass ein solcher Wafer vollkommen instabil wäre.

Weitere allgemein bekannte vertikale Halbleiterbauelemente mit Anschlüssen an gegenüberliegenden Oberflächen eines Halbleiterkörpers sind Dioden, die aus Stabilitätsgründen üblicherweise ebenfalls ein gut elektrisch leitendes Substrat aufweisen, auf welches - beispielsweise mittels Epitaxie - Halbleiterschichten aufgebracht sind, die einen pn-Übergang bilden und deren Dotierung und Abmessungen die elektrischen Eigenschaften der Diode bestimmen.

Um einerseits eine ausreichende mechanische Stabilität des Wafers bei der Herstellung zu gewährleisten, die nur durch eine gewisse Dicke sichergestellt werden kann, und andererseits die Auswirkungen dieser zur Herstellung erforderlichen Dicke auf das Bauelement möglichst gering zu halten, sind neben der genannten Möglichkeit, auf ein gut leitendes Substrat Epitaxie-Schichten aufzubringen, die die elektrischen Eigenschaften bestimmen, weitere Vorgehensweisen allgemein bekannt.

So ist es allgemein bekannt, einen Wafer vorzusehen, der eine Dotierung aufweist, die den Anforderungen an die Dotierung in Bereichen des Halbleiterbauelements, beispielsweise der Driftzone, genügt und den Wafer anschließend in den Bereichen, die einen Einfluss auf die elektrischen Eigenschaften des Bauelements haben, zu dünnen.

Des weiteren ist es allgemein bekannt, wenn auf eine Epitaxie verzichtet werden soll, einen schwächer dotierten Wafer zu verwenden und den Wafer von einer Rückseite her mittels einer Tiefdiffusion zu dotieren, um so einen niedrigen Widerstand des Wafers in den Bereichen zu erzeugen, die lediglich zur mechanischen Stabilität beitragen, und das oberhalb dieser Bereiche ausgebildete Halbleiterbauelemente von der Rückseite her niederohmig kontaktieren zu können.

Ziel der vorliegenden Erfindung ist es, ein Verfahren zur Herstellung eines Halbleiterbauelements zur Verfügung zu stellen, bei dem ein Wafer in dem eine Vielzahl von Bauelementen hergestellt werden, eine für die Handhabung des Wafers während des Herstellungsverfahrens ausreichende Dicke aufweisen darf und bei dem der Bereich des Wafers bzw. des späteren Chips, der keinen aktiven Bereich des Bauelements bildet einen geringen elektrischen Widerstand aufweist.

Diese Aufgabe wird durch ein Verfahren gemäß der Merkmale des Anspruchs 1 gelöst.

Vorteilhafte Ausgestaltungen der Erfindung sind Gegenstand der Unteransprüche.

Das erfindungsgemäße Verfahren zur Herstellung eines Halbleiterbauelements sieht vor, einen Halbleiterkörper mit einer ersten und einer zweiten Oberfläche zur Verfügung zu stellen und eine Vielzahl von Poren zu erzeugen, die sich ausgehend von der ersten Oberflächen in den Halbleiterkörper hinein erstrecken und die unterhalb der zweiten Oberfläche enden. Anschließend wird die elektrische Leitfähigkeit des Halbleiterkörpers im Bereich der Poren gesteigert. Dies erfolgt beispielsweise durch Eindiffundieren von Dotierstoffatomen in Bereiche des Halbleiterkörpers, die in den Poren freiliegen und/oder durch Auffüllen der Poren mit einem elektrisch leitenden Material, insbesondere einem Metall oder Polysilizium.

Der nicht von den Poren durchsetzte Bereich des Halbleiterkörpers unterhalb der zweiten Oberfläche kann zur Realisierung der aktiven Bereiche des eigentlichen Halbleiterbauelements, beispielsweise einer Diode oder eines Transistors, genutzt werden. Diese aktiven Bereiche können vor der Erzeugung der Poren oder nach der Erzeugung der Poren hergestellt werden. Die Tiefe, bis in welche die Poren ausgehend von der ersten Oberfläche in den Halbleiterkörper eingebracht werden, ist so auf die Dicke des Halbleiterkörpers bzw. des Wafers, der eine Vielzahl der späteren Halbleiterkörper/Chips bildet, abgestimmt, dass zwischen dem im Halbleiterkörper liegenden Ende der Poren und der zweiten Oberfläche eine Halbleiterschicht verbleibt, die eine Dicke aufweist, die zur Realisierung des gewünschten Bauelements geeignet ist. Das erfindungsgemäße Verfahren ist dabei insbesondere bei der Herstellung von PIN-Fotodioden geeignet.

Die Werte für die Eindringtiefe der Poren in den Halbleiterkörper liegen beispielsweise im Bereich zwischen 50% und 95% der Gesamtdicke des Halbleiterkörpers in Richtung der Poren.

Elektrisch verhält sich der Halbleiterkörper, dessen elektrische Leitfähigkeit im Bereich der Poren gesteigert wurde, annäherungsweise wie ein dünnes Substrat, das lediglich die Dicke der nicht von Poren durchsetzten Schicht des Halbleiterkörpers aufweist und das über den gut elektrisch leitenden porösen Bereich von der zweiten Oberfläche des Halbleiterkörpers her kontaktierbar ist.

Die vorliegende Erfindung wird nachfolgend in Ausführungsbeispielen anhand von Figuren näher erläutert. In den Figuren zeigt
- Figur 1: einen Ausschnitt eines Halbleiterkörpers/Wafers während verschiedener Verfahrensschritte eines erfindungsgemäßen Verfahrens zur Herstellung eines Halbleiterbauelements,
- Figur 2: einen Ausschnitt eines Halbleiterkörpers/Wafers, bei dem die elektrische Leitfähigkeit im Bereich der Poren durch Auffüllen der Poren mit einem elektrisch leitenden Material gesteigert wurde,
- Figur 3: ein erfindungsgemäßes Halbleiterbauelement gemäß einer ersten Ausführungsform der Erfindung,
- Figur 4: ein erfindungsgemäßen Halbleiterbauelement gemäß einer zweiten Ausführungsform der Erfindung.

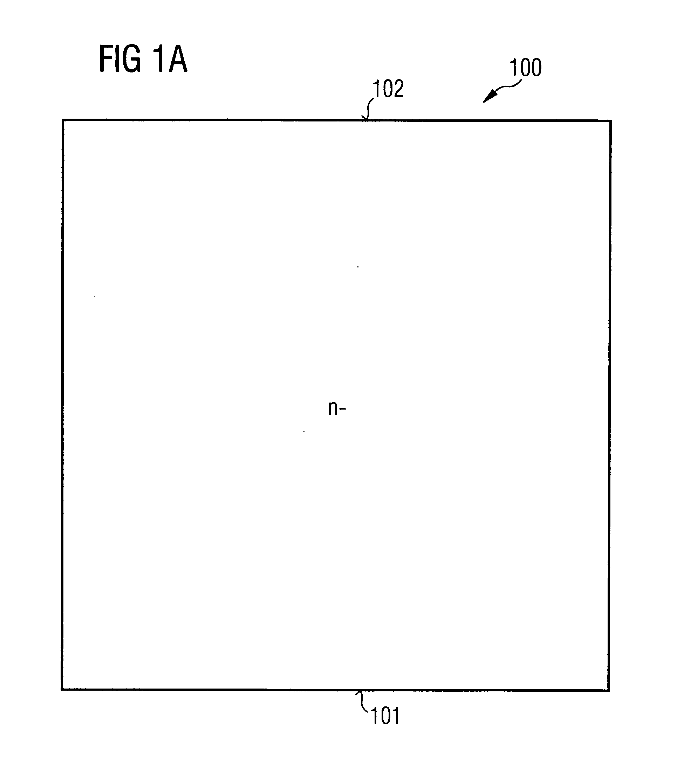

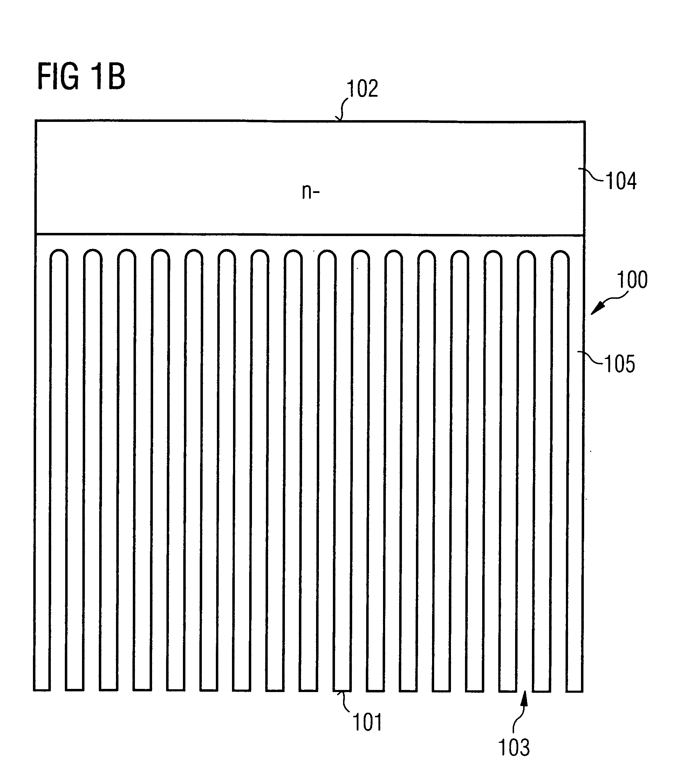

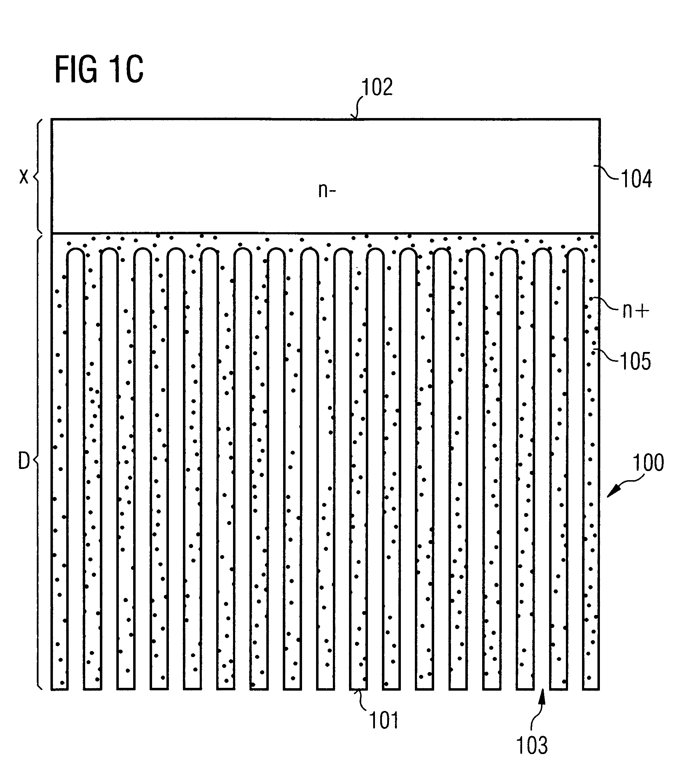

Figur 1 veranschaulicht erfindungsgemäße Verfahrensschritte während der Herstellung eines Halbleiterbauelements, wobei Figur 1 einen Ausschnitt eines Halbleiterkörpers oder eines Wafers, aus dem eine Vielzahl der späteren Halbleiterkörper/Chips herausgesägt werden, im Querschnitt zeigt.

In einem ersten Verfahrensschritt wird, wie in Figur 1a dargestellt ist, ein Halbleiterkörper 100 zur Verfügung gestellt, der eine erste Oberfläche 101 und eine zweite Oberfläche 102 aufweist.

Anschließend werden ausgehend von der ersten Oberfläche 101 Poren in dem Halbleiterkörper 100 erzeugt, die unterhalb der zweiten Oberfläche 102 des Halbleiterkörpers enden, wie in Figur 1b dargestellt ist. Zur Herstellung der Poren 103 eignet sich beispielsweise das in der EP 0 296 348 A1 beschriebene elektrochemische makroporöse Ätzverfahren.

Zudem wird, wie in Figur 1c dargestellt ist, die elektrische Leitfähigkeit des Halbleiterkörpers im Bereich der Poren 103 gesteigert. Dazu ist gemäß einer ersten Ausführungsform des Verfahrens vorgesehen, ausgehend von der ersten Oberfläche 101 Dotierstoffatome, insbesondere Donatoratome in Bereiche des Halbleiterkörper 100 einzudotieren, die in den Poren freiliegen, und die Dotierstoffatome anschließend in den Halbleiterkörper mittels eines Temperaturschritts eindiffundieren zu lassen. Die Diffusionstiefe und die Abstände benachbarter Poren 103 sind vorzugsweise so aufeinander abgestimmt, dass die zwischen den Poren liegenden Bereiche vollständig dotiert werden und anschließend eine hohe Dotierung aufweisen. Der in Figur 1a dargestellte Halbleiterkörper 100 ist in dem Beispiel zu Beginn des Verfahrens schwach n-dotiert, wobei zur Steigerung der elektrischen Leitfähigkeit im Bereich der Poren 103 eine starke n-Dotierung erfolgt.

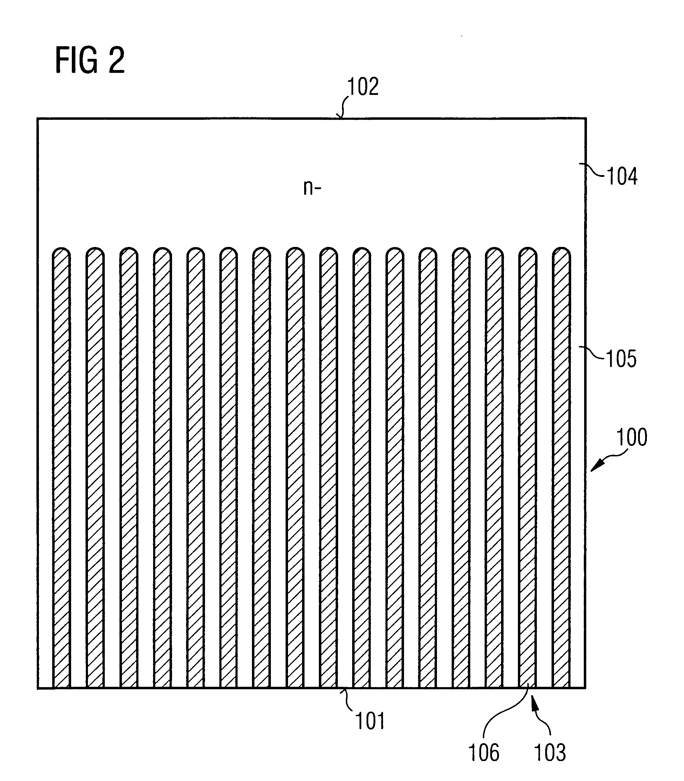

Zur Steigerung der elektrischen Leitfähigkeit im Bereich der Poren kann zusätzlich oder alternativ vorgesehen werden, die Poren 103 mit einem elektrisch leitenden Material, insbesondere einem Metall, beispielsweise Kupfer, oder Polysilizium aufzufüllen. Figur 2 zeigt einen Halbleiterkörper 100, dessen Poren 103 mit einem leitenden Material aufgefüllt wurden.

Bei den in den Figuren 1 und 2 dargestellten Ausführungsbeispielen nimmt der Bereich mit gesteigerter elektrischer Leitfähigkeit einen Bereich 105 mit einer Dicke D ein. Ein Bereich 104 mit einer Dicke x oberhalb des Bereiches 105 mit gesteigerter elektrischer Leitfähigkeit verbleibt für die Realisierung von aktiven Bereichen von Halbleiterbauelementen. Die Dicke D ist vorzugsweise größer als die Dicke x und beträgt beispielsweise zwischen 50% und 95% der Gesamtdicke des Halbleiterkörpers (D+x).

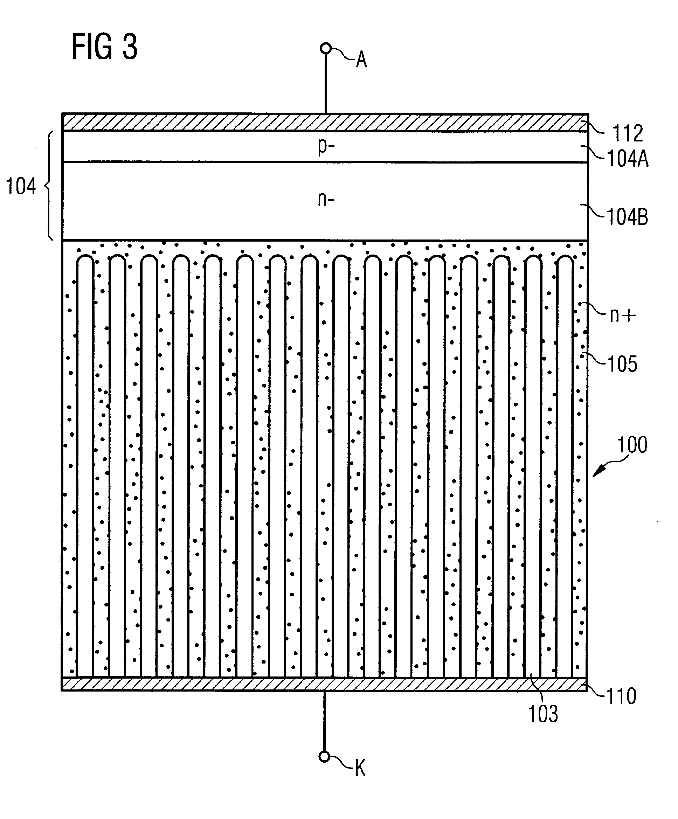

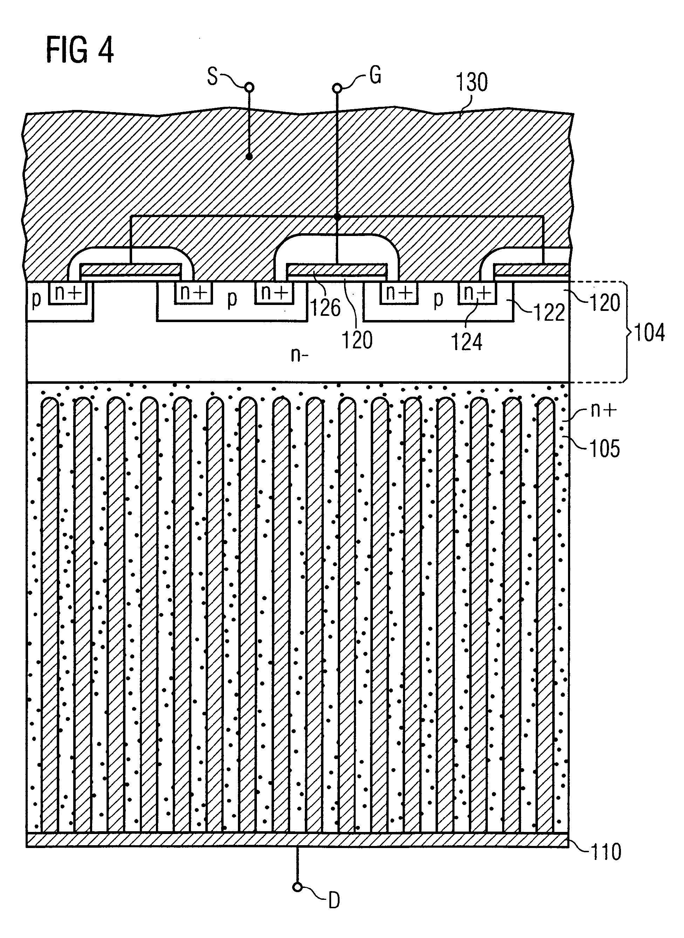

Der Bereich 105, trägt im wesentlichen zur mechanischen Stabilität eines Wafers bei der Herstellung von Halbleiterbauelementen in dem Bereich 104 bei, wobei die Ausdehnung des Wafers in lateraler Richtung die Dicke D, bzw. die Summe aus den Dicken D und x, um mehrere Größenordnungen übersteigt. Der Bereich D dient somit im wesentlichen als Trägerschicht für die Schicht 104, in der Halbleiterbauelemente ausgebildet sein können, wie anhand der Figuren 3 und 4 noch erläutert wird. Des weiteren dient der Bereich 105 als Anschlusszone für diese Halbleiterbauelemente, wobei die Maßnahme, die elektrische Leitfähigkeit des Bereiches 105 durch Dotierung und/oder Auffüllen der Poren 103 mit einem leitenden Material zu steigern, dem Bestreben Rechnung trägt, dass die Anschlusszone 105 möglichst nicht zur Steigerung des elektrischen Widerstandes des Halbleiterbauelementes beitragen soll.

Die Zone 104 des Halbleiterkörpers wirkt wie ein dünnes Substrat, das über die Zone 105 von der ersten Oberfläche 101 des Halbleiterkörpers 100 her niederohmig kontaktierbar ist.

Zusätzlich bewirkt diese Dotierung aus den Poren 103 heraus dass in diesem Bereich die Lebensdauer für, beispielsweise durch Licht generierte, Elektron-Loch-Paare sehr niedrig ist. Dadurch lassen sich sehr schnelle PIN-Dioden realisieren.

Figur 3 zeigt in Seitenansicht im Querschnitt eine Diode, die in einem mittels einem Verfahren gemäß der Figuren 1 oder 2 bearbeiteten Halbleiterkörper integriert ist. Der Bereich 105 mit den Poren 103 ist mittels einer auf die erste Oberfläche 101 aufgebrachten Kontaktschicht 110, vorzugsweise einem Metall kontaktiert. Ausgehend von der zweiten Oberfläche 102 wurde mittels hinlänglich bekannter Verfahren eine p-dotierte Zone 104A in dem Bereich 104 erzeugt, die durch eine Kontaktschicht 112 kontaktiert ist. Die p-dotierte Zone 104A bildet die Anodenzone, die n-dotierte Zone 104B bildet die Kathodenzone der Diode. Die ursprüngliche Dotierung des Halbleiterkörpers 100 ist vorzugsweise so gewählt, dass sie zur Bildung der späteren Kathodenzone 104B der Diode geeignet ist.

Figur 4 zeigt in Seitenansicht im Querschnitt einen vertikalen MOS-Transistor, der in einem mittels eines Verfahrens gemäß der Figuren 1 oder 2 bearbeiteten Halbleiterkörper integriert ist. Zur Herstellung des Transistors wurden in die n-dotierte Zone 104 p-dotierte Body-Zonen eingebracht, in die wiederum stark n-dotierte Source-Zonen 122 eingebracht wurden. Die Source-Zonen 122 und die Body-Zonen 120 sind mittels einer Source-Elektrode 130 kurzgeschlossen, die auf die zweite Oberfläche 102 des Halbleiterkörpers 100 aufgebracht ist. Ein Abschnitt 120 der Zone 104 bildet die Driftzone des MOS-Transistors, die über den porösen Bereich 105 durch eine auf der ersten Oberfläche 101 aufgebrachte Anschlussschicht 110, die die Drain-Elektrode bildet, kontaktiert ist. Oberhalb der zweiten Oberfläche 102 des Halbleiterkörpers 100 sind weiterhin Gate-Elektroden 126 vorgesehen, die mittels Isolationsschichten 128 gegenüber dem Halbleiterkörper 100 und der Source-Elektrode 130 isoliert sind.

Bei dem MOS-Transistor gemäß Figur 4 ist eine Dotierung des Halbleiterkörpers im Bereich der Poren 103 vorgesehen und die Poren 103 sind mit einem elektrisch leitenden Material aufgefüllt. Die ursprüngliche Dotierung des Halbleiterkörpers 100 ist so gewählt ist, dass sie zur Bildung der Driftzone 120 geeignet ist.

Während bei der obigen Beschreibung davon ausgegangen wurde, dass die aktiven Bereiche der Halbleiterbauelemente nach der Herstellung der Poren 103 erzeugt werden, besteht selbstverständlich auch die Möglichkeit, die aktiven Bereiche der Halbleiterbauelemente vor der Erzeugung der Poren 103 in dem Halbleiterkörper 100 herzustellen.

Das erfindungsgemäße Verfahren, bei dem die Leitfähigkeit eines Halbleitermaterials durch Herstellen von Poren und Steigern der elektrischen Leitfähigkeit im Bereich der Poren gesteigert wird, eignet sich für die Herstellung beliebiger vertikaler Halbleiterbauelemente, wobei der die Poren aufweisende Halbleiterkörper mit gesteigerter Leitfähigkeit als Ersatz für bekannte Trägermaterialien, einschließlich Epi-Materialien dient.

### Bezugszeichenliste

- 100: Halbleiterkörper
- 101: Erste Oberfläche
- 102: Zweite Oberfläche
- 103: Poren
- 105: Poröser Bereich
- 110, 112: Anschlussschicht
- 120: Driftzone
- 122: Body-Zone
- 124: Source-Zone
- 126: Gate-Elektrode
- 128: Isolationsschicht
- 130: Source-Elektrode
- A: Anode
- D: Drain-Anschluss
- G: Gate-Anschluss
- K: Kathode
- S: Source-Anschluss

## Patentansprüche

1. Verfahren zur Herstellung eines Halbleiterbauelements, das folgende Merkmale aufweist:
- Bereitstellen eines Halbleiterkörpers (100) mit einer ersten und einer zweiten Oberfläche (101, 102),
- Herstellen einer Vielzahl von Poren (103) in dem Halbleiterkörper (100), die sich ausgehend von der ersten Oberfläche (101) in den Halbleiterkörper (100) hinein erstrecken und die unterhalb der zweiten Oberfläche (102) enden,
- Steigern der elektrischen Leitfähigkeit des Halbleiterkörpers (100) im Bereich der Poren (103).

2. Verfahren nach Anspruch 1, bei dem in den Poren (103) freiliegende Bereiche des Halbleiterkörpers (100) dotiert werden.

3. Verfahren nach Anspruch 2, bei dem sich ein Diffusionsschritt an den Dotierschritt anschließt.

4. Verfahren nach Anspruch 1 oder 2, bei dem die Poren (103) wenigstens teilweise mit einem elektrisch leitfähigen Material, insbesondere einem Metall oder Polysilizium aufgefüllt werden.

5. Verfahren nach einem der vorangehenden Ansprüche, bei dem sich die Poren (103) bis zu einer Tiefe in den Halbleiterkörper (100) erstrecken, die zwischen 50% und 95% der Dicke des Halbleiterkörpers (100) beträgt.

6. Halbleiterbauelement, das folgende Merkmale aufweist:
- einen Halbleiterkörper (100) mit einer ersten und zweiten Oberfläche (101, 102) die jeweils Anschlusskontakte (110, 112; 110, 130) aufweisen,
- eine Vielzahl von Poren (103), die sich ausgehend von der ersten Oberfläche (101) in den Halbleiterkörper (100) hinein erstrecken und die unterhalb der zweiten Oberfläche (102) enden, wobei das Bauelement im Bereich der Poren (103) eine gesteigerte elektrische Leitfähigkeit aufweist.

7. Halbleiterbauelement nach Anspruch 6, bei dem der Halbleiterkörper an Seitenwänden der Poren (103) dotiert ist.

8. Halbleiterbauelement nach Anspruch 6 oder 7, bei dem die Poren (103) wenigstens teilweise mit einem elektrisch leitenden Material aufgefüllt sind.

9. Halbleiterbauelement nach Anspruch 8, bei dem das elektrisch leitende Material ein Metall oder Polysilizium ist.

10. Halbleiterbauelement nach einem der Ansprüche 6 bis 9, bei der sich die Poren (103) bis zu einer Tiefe in den Halbleiterkörper (100) erstrecken, die zwischen 50% und 95% der Dicke des Halbleiterkörpers (100) beträgt.
